# EUROPEAN PATENT APPLICATION

(11) **EP 1 391 544 A2**
(43) Date of publication of application: **25.02.2004**
(21) Application number: 03018876.7
(22) Date of filing: 19.08.2003
(51) Int. Cl.: C30B 29/28, C30B 13/00

(54) **Method for manufacturing terbium aluminium-based paramagnetic garnet single crystal**

(30) Priority: 22.08.2002 JP 2002242047; 20.09.2002 JP 2002275990; 08.08.2003 JP 2003290578
(71) Applicant: Murata Manufacturing Co., Ltd., Nagaokakyo-shi Kyoto-fu 617-8555 (JP)
(72) Inventor: Sekijima, Takenori, (A 170), Nagaokakyo-shi, Kyoto-fu 617-8555 (JP); Geho, Mikio, (A 170), Nagaokakyo-shi, Kyoto-fu 617-8555 (JP)
(74) Representative: Laufhütte, Dieter, Dr.-Ing.

(57) **Abstract**

A method for manufacturing a terbium aluminum-based paramagnetic garnet single crystal which can easily produce a TAG single crystal having a large Faraday effect and a high light-transmittance even in the visual light range is provided, and the crystal, therefore is, usable as a material for a magneto-optical device. The method is for manufacturing a terbium aluminum-based paramagnetic garnet single crystal grown by a laser FZ method using a raw material rod made of paramagnetic garnet containing at least Tb and Al and a seed crystal, while at least one of the raw material rod and the seed crystal is porous, and the method can include the steps of preparing the raw material rod, preparing the seed crystal, melt-joining the raw material rod and the seed crystal, heat-melting the joint of the seed crystal and the raw material rod by application of optical energy thereto so as to prepare a melt zone, and cooling the resulting melt zone.

## Description

### BACKGROUND OF THE INVENTION

### 1. Field of the Invention

The present invention relates to a method for manufacturing a terbium aluminum-based paramagnetic garnet single crystal containing at least Tb and A1. For example, the present invention relates to a method for manufacturing a terbium aluminum-based paramagnetic garnet single crystal used for optical isolators, optical circulators, and the like for optical communication and optical recording.

### 2. Description of the Related Art

In recent years, the speeds and capacities of communication devices including conventional metal communication lines have become insufficient due to an increase in the amount of information communication, and therefore, an optical communication technology has been noted as a high-speed, large-capacity information communication technology. Research and development on the high-speed, large-capacity information communication technology employing the use of extremely low-loss transmission characteristic of a quartz fiber in the infrared region (wavelength is 1,300 to 1,600 nm) in combination with high-density wavelength division multiplexing technology (DWDM) have been actively pursued as the currently predominant optical communication technology.

An improvement in the characteristics of and reduction in the cost of optical components supporting the optical communication technology in terms of hardware become important. Under these circumstances, magneto-optical devices based on the interaction between light and magnetism has also become important. The magneto-optical devices are required to have material characteristics including, in particular, (1) a large Faraday effect and (2) a high light-transmittance.

Magnetic materials satisfying the above-described conditions include a single crystal of terbium aluminum paramagnetic garnet (Tb₃Al₅O₁₂: hereafter referred to as TAG) containing Tb and A1. This TAG single crystal has a Verdet constant (deg/(Oe·cm)) significantly larger than that of the other paramagnetic materials, where the Verdet constant shows the magnitude of a Faraday rotation angle of a paramagnetic material on a unit length and a unit magnetic field basis. Consequently, a sufficient Faraday rotation angle can be achieved even when the size of the single crystal is decreased, and thereby, the magneto-optical device can be miniaturized. Since the magnet for applying a magnetic field can be made small, not only the magneto-optical device itself can be miniaturized, but also the influence of the magnetic field on the other electronic components can be reduced to a minimum level, and the functions of the magneto-optical device can be stabilized. Furthermore, the TAG single crystal has sufficiently high light-transmittance in a wide wavelength range of light of 500 nm to 1,400 nm. In particular, it is also clear that a high light-transmittance can be achieved in the visible light range in which the wavelength of light is 400 nm to 700 nm. It is desired to make full use of the TAG single crystal having such excellent characteristics for magneto-optical devices.

However, the TAG single crystal having such excellent characteristics is an incongruent melting type compound, and there is a problem in that melt composition resulting from melting of the starting material is different from the crystal composition resulting from cooling of the melt. Specifically, the micro pull-down method (µ-PD method) shown in V.I. Chani et al., J. Crystal Growth 212 (2000) 469-475, the Czocklarski (Cz) method shown in S. Ganschow et al., Cryst. Res. Technol., 34 (1999) 615 and the like are conventionally used. More specifically, in the micro pull-down method, an opening is provided at the bottom of a crucible made of Pt, and a seed crystal is arranged at the opening of the crucible from the outside of the crucible. A polycrystal separately put into the crucible is heat-melted, and the seed crystal and the polycrystal are joined. The seed crystal is pulled down from the outside, and thereby, a single crystal grows. In the Czocklarski method, a calcined mixed powder of Tb₄O₇ and Al₂O₃ as starting materials is filled in an Ir crucible, and is melted by high-frequency induction heating. After the seed crystal is brought into contact with the molten liquid so as to sufficiently conform the molten liquid, the seed crystal is pulled up while being rotated at a constant speed, and thereby, a TAG single crystal grows. However, when such a direct melt-textured growth process is used, with respect to the incongruent melting type TAG single crystal, the garnet phase TAG single crystal cannot be directly produced from a melt composition of molten starting materials, and there is a problem in that perovskite phase TbAlO₃ is also present in addition to the TAG single crystal. In consideration of the above-described problem, it is attempted to form through the use of a flux method shown in C. B. Rubinstein et al., J. Appl. Phys., 35 (1964) 3069. Specifically, a solution is prepared in the flux method, in which Tb₄O₇ and Al₂O₃ as starting materials are dissolved as solutes into a solvent of PbF₂ or the like. The seed crystal is put into this solution, followed by gradual cooling, and thereby, a bulk type TAG single crystal is produced. However, when these manufacturing methods are used, a few days to a few weeks are required for production of the TAG single crystal, and furthermore, only a small crystal having a length of a short 1 to 2 mm can be produced. Therefore, no TAG single crystal having a practicable size can be produced.

For the above-described reasons, no TAG single crystal can be produced, or only a small crystal can be produced. Consequently, no TAG single crystal having excellent characteristics can become in practical use as a material for an magneto-optical device.

### SUMMARY OF THE INVENTION

The present invention overcomes the above-described problems. Accordingly, it is an object of the present invention to provide a method for manufacturing a terbium aluminum-based paramagnetic garnet single crystal, which can easily produce a TAG single crystal having a large Faraday effect and a high light-transmittance even in the visual light range, and therefore, usable as a material for a magneto-optical device.

In order to achieve the above-described objects, a method for manufacturing a terbium aluminum-based paramagnetic garnet single crystal according to a first aspect of the present invention is a method for manufacturing a terbium aluminum-based paramagnetic garnet single crystal grown by a laser FZ method using a raw material rod made of paramagnetic garnet containing at least Tb and A1 and a seed crystal, while at least one of the above-described raw material rod and the above-described seed crystal is porous, and the method includes the steps of preparing the above-described raw material rod, as a first step, preparing the above-described seed crystal, and melt-joining the above-described raw material rod and the above-described seed crystal, as a second step, heat-melting the joint of the above-described seed crystal and the above-described raw material rod by application of optical energy thereto so as to prepare a melt zone, as a third step, and cooling the resulting melt zone, as a fourth step.

By adopting the above-described manufacturing method, a TAG single crystal can easily be generated while generated TbAlO₃ is removed from the melt zone, and the TAG single crystal having a size which cannot be achieved by conventional manufacturing methods can easily be produced. In this manner, the number of chips cut from the TAG single crystal can be increased, and therefore, full use as a material for magneto-optical devices can be made. With respect to incongruent melting type Tb₃Al₅O₁₂ in the conventional manufacturing method, TbAlO₃ is initially generated in the solid-liquid interface between the melt zone and the solid, and thereafter, Tb₃Al₅O₁₂ is generated. Consequently, TbAlO₃ and Tb₃Al₅O₁₂ are inevitably brought into a mixed state. However, the inventors of the present invention found that when the joint of a seed crystal and a raw material rod was heat-melted, the molten liquid penetrates into a porous medium, and an initial phase of TbAlO₃ was deposited on a priority basis in the porous medium. Consequently, at least one of the seed crystal and the raw material rod is adjusted to be porous, the joint, that is, the solid-liquid interface between the melt zone and the solid, is heat-melted by application of optical energy thereto, and therefore, the initial phase of TbAlO₃ is deposited in this porous medium, so that TbAlO₃ is removed from the melt zone, and thereby, a larger Tb₃Al₅O₁₂ single phase can be achieved.

With respect to a method for manufacturing a terbium aluminum-based paramagnetic garnet single crystal according to a second aspect of the present invention, preferably, one of the above-described raw material rod and the above-described seed crystal has a density of about 55% or more, but 100% or less, and the other has a density of about 55 % or more, but about 85 % or less.

By adjusting the raw material rod and the seed crystal to have the densities within the above-described range, TbAlO₃ is prevented from depositing in the single crystal, and the Tb₃Al₅O₁₂ single crystal can be stably formed. The term "density" here represents the relative density with respect to the theoretical density of the starting material composition.

With respect to a method for manufacturing a terbium aluminum-based paramagnetic garnet single crystal according to a third aspect of the present invention, preferably, the above-described seed crystal has a density of about 55 % or more, but about 85 % or less and the above-described raw material rod has a density of about 55% or more, but 100% or less.

By adjusting the raw material rod and the seed crystal to have the densities within the above-described range, TbAlO₃ is prevented from depositing in the single crystal, and the Tb₃Al₅O₁₂ single crystal can be stably formed. Furthermore, a larger Tb₃Al₅O₁₂ single crystal having a diameter of about 3 mm or more can be stably formed.

With respect to a method for manufacturing a terbium aluminum-based paramagnetic garnet single crystal according to a fourth aspect of the present invention, preferably, one of a Tb₃Al₅O₁₂ single crystal, a Tb₃Al₅O₁₂ polycrystal and Y₃Al₅O₁₂ is used as the above-described seed crystal.

When the seed crystal according to the fourth aspect of the present invention is used in the first to third aspects of the present invention, the seed crystal is likely to be melt-joined to the raw material rod containing at least Tb and A1. This provides advantages in that the TAG-based single crystal can be produced while TbAlO₃ is prevented from depositing in the single crystal, and the TAG-based single crystal has a size which cannot be conventionally achieved.

With respect to a method for manufacturing a terbium aluminum-based paramagnetic garnet single crystal according to a fifth aspect of the present invention, preferably, Tb₃Al₅O₁₂ or (RTb)₃Al₅O₁₂ (where R represents at least one of the rare-earth elements) is used as the above-described raw material rod. It is advantageous to use the fifth aspect in the first to third aspects because even when a rare-earth element, e.g. Dy, Ho, Er or Tm, is substituted for Tb in the basic composition of the terbium aluminum-based paramagnetic garnet single crystal, as described above, the TAG-based single crystal can be produced while TbAlO₃ is prevented from depositing in the single crystal, and the TAG-based single crystal has a large size and excellent quality which cannot be conventionally achieved.

With respect to a method for manufacturing a terbium aluminum-based paramagnetic garnet single crystal according to a sixth aspect of the present invention, preferably, the joint of the above-described raw material rod and the above-described seed crystal is heat-melted by application of CO₂ gas laser light thereto in the above-described third step.

By adopting the above-described manufacturing method, the raw material rod can efficiently absorb the laser light, and the joint of the seed crystal and the raw material rod can easily be heat-melted.

With respect to a method for manufacturing a terbium aluminum-based paramagnetic garnet single crystal according to a seventh aspect of the present invention, preferably, the laser light is condensed before the laser light is applied to the joint of the above-described raw material rod and the above-described seed crystal, in the above-described third step.

By adopting the above-described manufacturing method, the laser light is intensively applied to a part of the joint of the seed crystal and the raw material rod, and thereby, steeper, larger optical energy can be applied.

As described above, by adopting the method for manufacturing a terbium aluminum-based paramagnetic garnet single crystal according to the present invention, the TAG single crystal can easily be produced, and the TAG-based single crystals can be suitably used as materials for magneto-optical devices.

By adopting the method for manufacturing a terbium aluminum-based paramagnetic garnet single crystal according to the second aspect of the present invention, the raw material rod and the seed crystal are adjusted to have the densities within the above-described range. Consequently, TbAlO₃ is prevented from depositing in the single crystal, and the Tb₃Al₅O₁₂ single crystal can be stably formed.

By adopting the method for manufacturing a terbium aluminum-based paramagnetic garnet single crystal according to the third aspect of the present invention, the raw material rod and the seed crystal are adjusted to have the densities within the above-described range. Consequently, TbAlO₃ is prevented from depositing in the single crystal, and the Tb₃Al₅O₁₂ single crystal can be stably formed. Furthermore, a larger Tb₃Al₅O₁₂ single crystal having a diameter of about 3 mm or more can be stably formed.

By using the seed crystal according to the fourth aspect of the present invention, the seed crystal is likely to be melt-joined to the paramagnetic garnet polycrystal containing at least Tb and A1. This provides advantages in that the TAG-based single crystal can be produced while TbAlO₃ is prevented from depositing in the single crystal, and the TAG-based single crystal has a size which cannot be conventionally achieved.

With respect to the method for manufacturing a terbium aluminum-based paramagnetic garnet single crystal according to the fifth aspect of the present invention, even when a rare-earth element, e.g. Dy, Ho, Er or Tm, is substituted for Tb, a large TAG-based single crystal having excellent quality can be produced, and therefore, the method serves a useful function.

By adopting the method for manufacturing a terbium aluminum-based paramagnetic garnet single crystal according to the sixth aspect of the present invention, the melt zone in the joint of the raw material rod and the seed crystal can efficiently absorb the laser light, and the melting can be performed with ease. In this manner, large optical energy can be applied to the solid-liquid interface between the melt zone and the solid in the joint of the seed crystal and the raw material rod.

By adopting the method for manufacturing a terbium aluminum-based paramagnetic garnet single crystal according to the seventh aspect of the present invention, the laser light is intensively applied to a part of the joint of the seed crystal and the raw material rod, and thereby, large optical energy can be applied.

### BRIEF DESCRIPTION OF THE DRAW MATERIALINGS

Fig. 1 is a schematic perspective view of a laser FZ apparatus according to an embodiment of the present invention;
Fig. 2 is a vertical, sectional photograph in the vicinity of a joint of Tb₃Al₅O₁₂ and a seed crystal according to the present invention;
Fig. 3 is a graph showing a positional dependence of the Al composition relative to the Tb composition in a Tb₃Al₅O₁₂ single crystal prepared by the manufacturing method of the present invention;
Figs. 4A and 4B are reflection X-ray Laue photographs of a Tb₃Al₅O₁₂ single crystal according to the present invention and a seed crystal, respectively;
Figs. 5A and 5B are graphs showing the measurement results of the material identification of a Tb₃Al₅O₁₂ single crystal according to the present invention and a reference crystal, respectively, with an X-ray diffractometer; and
Fig. 6 is a graph showing a Pole-Figure of the <111> orientation of a Tb₃Al₅O₁₂ single crystal according to the present invention.

### DESCRIPTION OF THE PREFERRED EMBODIMENTS

Preferred embodiments of the present invention will be described below.

In the present invention, at least one of the raw material rod and the seed crystal is porous. By using such raw material rod and/or seed crystal, an initial phase of TbAlO₃ is deposited on a priority basis in the porous medium, so that TbAlO₃ is removed from the melt zone, and thereby, a Tb₃Al₅O₁₂ single phase can be produced.

Preferably, one of the above-described raw material rod and the above-described seed crystal has a density of about 55% or more, but 100% or less, and the other has a density of about 55 % or more, but about 85 % or less.

More preferably, the above-described seed crystal has a density of about 55 % or more, but about 85 % or less and the above-described raw material rod has a density of about 55% or more, but 100% or less. When the densities are adjusted to be within the above-described range, a larger Tb₃Al₅O₁₂ single crystal having a diameter of about 3 mm or more can be stably formed.

If the density of the raw material rod or the seed crystal is smaller than about 55%, the molten liquid excessively penetrates therein. Consequently, if the density of the raw material rod is smaller than about 55%, the melt zone becomes significantly slender, and problems occur in that only a slender single crystal is produced or the joint is broken. In particular, when the density of the seed crystal is less than about 55%, the strength is also reduced, and there is a problem in that the single crystal cannot be sufficiently held. If the density of the seed crystal is more than about 85%, the molten liquid cannot sufficiently penetrate into the porous medium and TbAlO₃ cannot be sufficiently removed from the melt zone, and may deposit in the single crystal.

Since Tb₃Al₅O₁₂ is an incongruent melting type compound, an initial phase of TbAlO₃ and a liquid phase result by incongruent melting when the crystal is melted. When the seed crystal and the raw material rod are joined, followed by heat-melting, the molten liquid penetrates into the holes in the seed crystal and the raw material rod. It is clear that TbAlO₃ is deposited on a priority basis in the porous medium at this time, and TbAlO₃ locates at the boundary between the melt zone and the raw material rod. On the other hand, the single crystal grows on the seed crystal. Since the density of the single crystal is 100%, the molten liquid penetrates simply in the raw material rod side during growth of the crystal. When the raw material rod and the seed crystal are moved in the same direction during growth of the crystal, TbAlO₃ also moves together with the melt zone in order to always locate at the boundary between the melt zone and the raw material rod. When the density of the raw material rod is about 55 % or more, but 100% or less at this time, excessive penetration of the molten liquid can be prevented. However, if the density is smaller than about 55%, the molten liquid excessively penetrates into the raw material rod. Consequently, the melt zone cannot be stably held, and thereby, the melt zone is broken.

Preferably, the density of the seed crystal is smaller than that of the raw material rod. That is, the molten liquid is made to penetrate into the seed crystal side immediately after the heat-melting of the joint and the initial phase of TbAlO₃ is made to deposit, and thereby, TbAlO₃ can be reliably prevented from depositing in the single crystal.

Even when the density of the seed crystal is more than about 85%, but 100% or less, and the density of the raw material rod is about 55% or more, but about 85% or less, a TAG single crystal having a diameter in the order of 1 mm can be stably supplied as a matter of course.

Examples of methods for manufacturing the above-described porous raw material rod and seed crystal can include, for example, a method in which starting materials, an organic binder and a solvent are mixed so as to prepare a mixture in a slurry state, and thereafter, the resulting mixture is sintered. Here, the TAG polycrystal is sintered at a firing temperature of about 1,500°C to 1,600°C. A low density TAG polycrystal is prepared by sintering at a lower temperature. The range of density of the TAG polycrystal of the present invention is adjusted by firing at a firing temperature of about 1,400°C to 1,600°C. In addition to this, the manufacture can be performed by changing the amount of addition of the above-described organic binder or by adjusting the firing time. The raw material rod used here is molded into the shape of a cylindrical column. However, any shape can be adopted as long as the shape is convenient for melt-joining to the seed crystal described below. For example, the shape of a rod, a thin plate and the like can also be adopted.

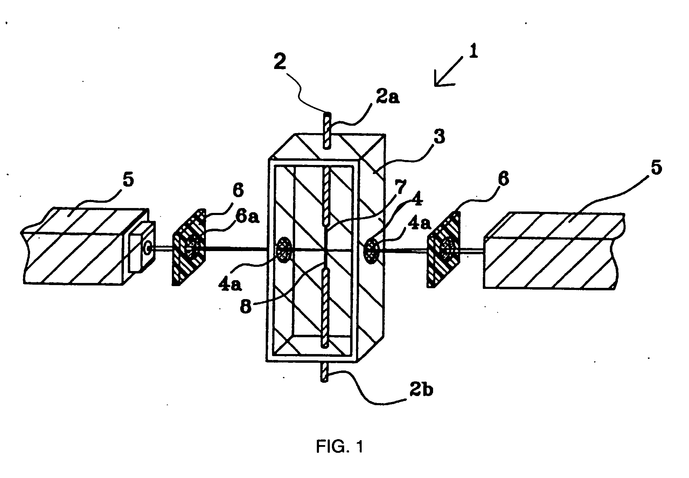

Explanations will be made with reference to a single crystal manufacturing apparatus suited for manufacturing the terbium aluminum-based paramagnetic garnet single crystal of the present invention. Fig. 1 is a schematic perspective view of a laser FZ (Floating zone) apparatus according to an embodiment of the present invention. This laser FZ apparatus 1 is composed of laser apparatuses 5 for lasing, a box 3 doubling as a radiating plate, in which an atmosphere can be adjusted, and a shaft 2 vertically movable in the box 3. The shaft 2 is a rod-shaped support which can be separated into an upper shaft 2a and a lower shaft 2b. The vertically movable shaft 2 is provided penetrating from the top surface to the bottom surface of the box 3. Each of the upper shaft 2a and the lower shaft 2b can hold a target. Window portions 4 are provided on both side surfaces of the box 3, and window portion lenses 4a are fit into the windows 4 in order that the laser light can be intensively applied to the joint of the target supported by the shaft 2a and the target for supporting supported by the shaft 2b. The laser apparatuses 5 are provided on both the side portions of the box 3 in order that the laser light can be applied through both window portions 4 of the box 3. The laser lights are emitted from the laser apparatuses 5 located in both side portions of the box 3, and thereby, the laser light is intensively applied from both directions to the targets supported by the shaft 2 through the window portion lenses 4a fit into the window portions 4 of the box 3.

The configuration in which shaft 2 can be moved in the axis direction, as described above, is preferable because the melting due to heating and solidification due to cooling can be successively performed. Preferably, the movement speed of the shaft is about 30 mm/hour or less, depending on the diameter of the TAG polycrystal used as the material. If the movement speed of the melt zone in the axis direction exceeds about 30 mm/hour, the crystal cannot be sufficiently melted, and it is difficult to convert the melt zone into a single crystal.

A range of wavelength, which is emitted by the laser apparatus 5, is 1.6µm and over, and less than 100µm. 100µm is an upper limit of wavelength of light. TAG single crystal transmits wavelength of less than 1.6µm. For that reason, a wavelength of the laser light, which is less than 1.6µm, is not absorbed in the raw material rod adequately. Therefore, a melting of the raw material rod is not sufficient.

As the laser apparatus 5, which can emit a wavelength is 1.6µm and more, a CO₂ gas laser is known. Since the CO₂ gas laser apparatus emits a laser light having a long wavelength and a TAG polycrystal having a wide transparent wavelength range can efficiently absorb the laser light, and therefore, the TAG polycrystal is melt-joined with ease. Alternatively, an excimer laser or the like may be used.

Two laser apparatuses 5 are provided here on both the side portions of the box 3, and the laser lights are applied to the shaft 2 from both side surfaces. However, the locations of arrangement of the laser apparatuses 5 are not limited to these. That is, it is essential only that the optical energy of the laser light is intensively applied to the joint of the TAG polycrystal and the seed crystal, and at least three laser apparatuses may be provided so that the laser light may also be applied from the location on the normal to the above-described joint. When a plurality of lasing sources are prepared, as described above, a steeper temperature gradient can be applied, and in addition, the irradiation area can be increased as well. Consequently, a TAG single crystal having a larger size can be produced.

The intensity of the laser light can be adjusted by adjusting the distance from the laser apparatus 5 to the shaft 2 holding a paramagnetic garnet single crystal 7 and a seed crystal 8. These laser lights can appropriately be adjusted depending on the size of the resulting crystal, the size of the box 3, the focal length of the lens 4 and the like.

In the present invention, a condenser lens element 6 is preferably, separately provided in order to apply the laser light more intensively to the end portion of the TAG polycrystal. Specifically, the condenser lens element 6 having a condenser lens 6a is an extension of the window portion of the box 3 and a lasing hole 5a of the laser apparatus 5, and is provided in such a location that the laser light is concentrated onto the end portion of the target for supported with the upper shaft 2a, through the window portion 4 of the box 3. The condenser lens 6a is not necessarily the same lens as the window portion lens 4a of the window portion 4 of the box 3. When a CO₂ gas laser is used, preferably, the condenser lens 6a is made of ZnSe. Other condenser lenses can also be used as long as those are devices capable of condensing the laser light.

The targets are the raw material rod and the seed crystal. The raw material rod may be held on the shaft 2a and the seed crystal may be held on the shaft 2b, or the seed crystal may be held on the shaft 2a and the raw material rod may be held on the shaft 2b.

The shaft 2a and the shaft 2b may be rotated at the same speed in the same direction in order that the laser light can be applied to a wide range of the joint of the target for supporting held on the shaft 2a and the target for supporting held on the shaft 2b.

The TAG-based single crystals prepared by the method for manufacturing a terbium aluminum-based paramagnetic garnet single crystal of the present invention can be used for magneto-optical devices, specifically, optical isolators, optical attenuators, optical switches, optical circulators and the like. Furthermore, the TAG-based single crystals can be used as materials for various magneto-optical sensors, e.g. rotation sensors, flow rate sensors and current sensors.

### Experimental example 1

A preferred embodiment of the method for manufacturing a terbium aluminum-based paramagnetic garnet single crystal of the present invention will be more specifically described below.

### Example 1

### 1. First step

As starting materials for a raw material rod, Tb₄O₇ (purity 99.9%) and Al₂O₃ (purity 99.99%) were prepared, followed by weighing in order to constitute Tb₃Al₅O₁₂. Pure water was added to the resulting mixed powder of the starting materials, and mixing was done for about 24 hours together with cobblestones. The resulting mixed powder was dehydrated with an aspirator, and dried with a drier. The resulting mixed powder was passed through a mesh so as to adjust the particle size of the mixed powder, and then calcined in an electric furnace at 1,200°C for 2 hours. After this calcining, the resulting mixed powder was pulverized, and an organic binder and a solvent were added thereto, and then mixed for a few hours together with cobblestones, so that a mixture in a slurry state was prepared. The resulting mixture was molded into the shape of a cylindrical column with a molding apparatus, followed by firing again in an electric furnace at 1,600°C for 2 hours, so that a cylindrical TAG polycrystal was produced. The resulting TAG polycrystal had a density of 80% .

### 2. Second step

The TAG polycrystal prepared in the first step is molded into to the shape of a cylindrical column having a diameter of 1 mm. The laser FZ apparatus 1 shown in Fig. 1 is used. The resulting cylindrical TAG polycrystal 7 is arranged while being held on one end of the upper shaft 2a of the laser FZ apparatus, and a seed crystal 8 made of a TAG single crystal is arranged at one end of the lower shaft 2b. The atmosphere in the box 3 is air, and the laser lights are applied from the laser apparatuses 5. Consequently, the end portion of the TAG polycrystal 7 arranged at one end of the upper shaft 2a is heated to the order of 1,900°C so as to be melted, and the molten portion is joined to the end portion of the seed crystal 8 arranged on the lower shaft 2b.

Next, by applying the laser lights to a melting-joint portion where the end portion of TAG polycrystal 7 and the end portion of the seed crystal 8 are jointed.

The distance from the laser apparatus 5 to the shaft 2 holding the paramagnetic garnet single crystal 7 and the seed crystal 8 is adjusted to be about 50 cm. As the laser apparatus 5 used here, specifically, a CO₂ gas laser apparatus capable of emitting a CO₂ gas laser light having a wavelength of 10.6 µm is used, and the output thereof is adjusted at 60 W.

### 3. Third step

A melt zone is formed by joining the end portion of the TAG polycrystal 7 and the end portion of the seed crystal 8 while the laser lights are applied thereto.

### 4. Fourth step

The shaft is moved down in the axis direction at a speed of 30 mm/hour or less, and thereby, an irradiation area of the laser lights is moved from the location irradiated with the laser light to the raw material rod of the melting-joint portion. In this manner, the melt zone is cooled, so that a crystal is produced.

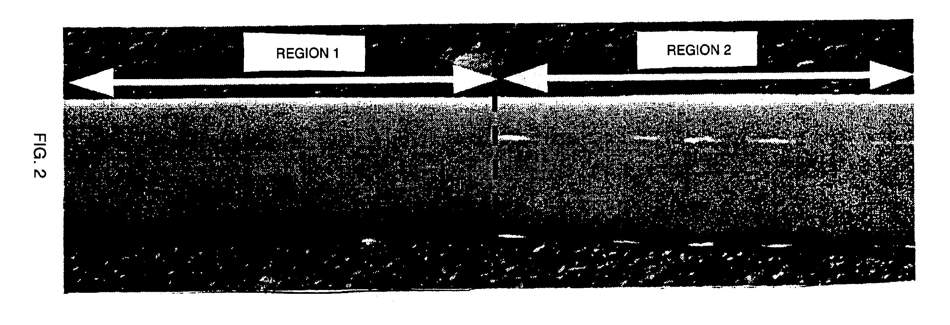

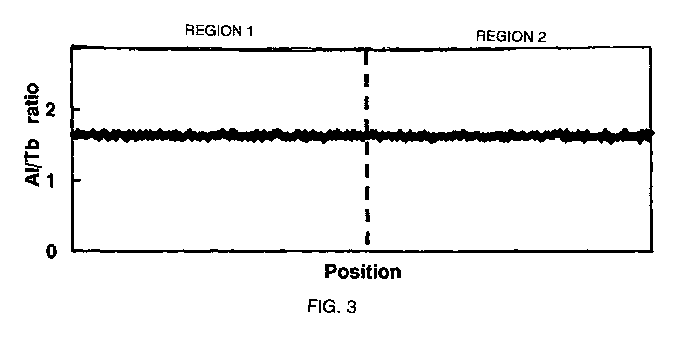

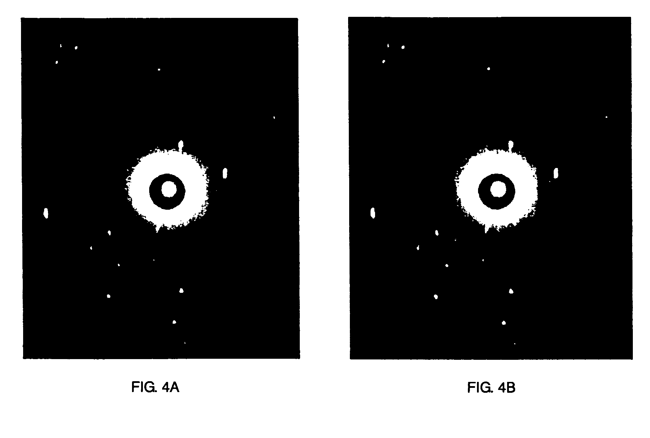

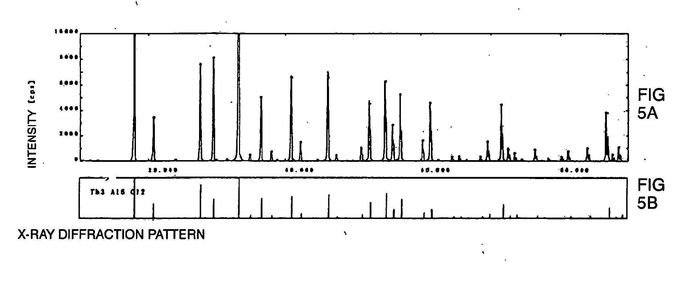

Evaluation was performed by the following methods with respect to whether the crystal produced as described above was a desired TAG single crystal. (1) Vertical, sectional photographs were taken with respect to the vicinity of the joint of the Tb₃Al₅O₁₂ single crystal used as the seed crystal and the resulting crystal. Fig. 2 reproduces a photograph of the seed crystal indicated as region 1 and the resulting crystal indicated as region 2. (2) With respect to the region 1 and the region 2, the surface of each crystal was irradiated with an electron beam, and thereby, a positional dependence of the A1 composition relative to the Tb composition was measured by line analysis using the WDX method (Wavelength Dispersive X-ray Spectroscopy) in which a characteristic X-ray inherent in the element contained in the crystal was detected. This is shown in Fig. 3. (3) A reflection X-ray Laue photograph was taken with respect to each of the Tb₃Al₅O₁₂ single crystal used as the seed crystal and the resulting crystal. This is shown in Fig. 4A. (4) The material identification was performed with an X-ray diffractometer which measured diffraction peaks based on the irradiation of the resulting crystal with an X-ray. The results are shown in Fig. 5.

As is clear from Fig. 2, no phase other than the garnet phase is deposited in the vicinity of the joint of region 1 (indicating the seed crystal) and region 2 (indicating the resulting crystal). With respect to the positional dependence of the A1 composition relative to the Tb composition, Al/Tb is a constant 1.67 at every position in the resulting crystal, as is clear from Fig. 3. In this manner, it is clear that the compositional ratio of A1 to Tb is the same at every position in region 1 and region 2. Furthermore, since the reflection X-ray Laue image of the Tb₃Al₅O₁₂ single crystal used as the seed crystal shown in Fig. 4A is in agreement with that of the resulting crystal shown in Fig. 4B, it is clear that the growing orientation can be controlled as well. Fig. 5B is a JCPDS card showing X-ray peak values of the garnet phase. X-ray peak values of the resulting crystal shown in Fig. 5A are in agreement with the X-ray peak values of the garnet phase shown in Fig. 5B, and no X-ray peak value other than that of the garnet phase was detected. In this manner, it is clear that the resulting crystal is a single phase of TAG. As is clear from the above-described results, the resulting crystal is a TAG single crystal represented by Tb₃Al₅O₁₂.

As is clear from the measurement of the shape of the resulting TAG single crystal, a fiber-shaped TAG single crystal of 1 mm in diameter and 27 mm in length is produced.

### Example 2

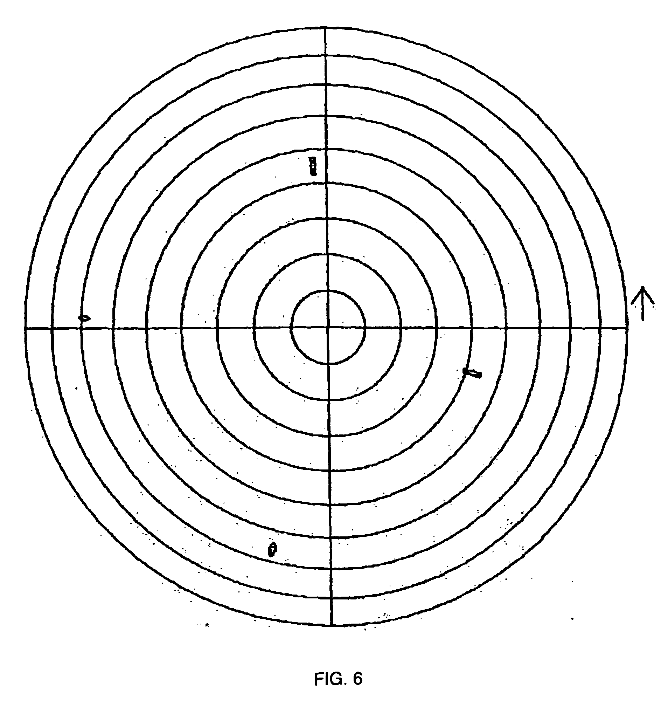

As starting materials for a raw material rod, Tb₄O₇ (purity 99.9%) and Al₂O₃ (purity 99.99%) were weighed, and a TAG polycrystal was prepared in a manner similar to that in Example 1. The density of the resulting TAG polycrystal was 80% . In the second step, a crystal was prepared in a manner similar to that in Example 1 except that the resulting TAG polycrystal 7 was held on one end of the upper shaft 2a of the laser FZ apparatus 1, and furthermore, this resulting TAG polycrystal 7 was arranged at one end of the lower shaft 2b as a seed crystal. Evaluation was performed by the following method with respect to whether the thus prepared crystal was a TAG single crystal. The resulting fiber-shaped crystal was cut in the direction of the radius to have the shape of a chip. This was set in an HR-XRD apparatus (X' pert manufactured by Philips), the diffraction angle was fixed in order that the reflection of the 100 appeared in the <111> orientation of the TAG single crystal, and the Pole-Figure was measured. The results thereof are shown in Fig. 6.

In Fig. 6, an arrow indicates the φ coordinate, the center of the concentric circles is φ = 0, and the outermost circle indicates φ = 90°. With respect to the resulting crystal, four reflections of the 100 forming an angle of φ = 69° with each other were identified and no other reflection of the 100 appeared.

Laue photographs were taken in a manner similar to that in (3) of Example 1. The reflection X-ray Laue image of the Tb₃Al₅O₁₂ single crystal is in agreement with that of the resulting crystal, and therefore, it is clear that the growing orientation can be controlled as well. The material identification of the resulting crystal was performed with an X-ray diffractometer in a manner similar to that in (4) of Example 1, and no X-ray peak value other than that of the garnet phase was detected. It is clear from the above description that the resulting crystal is a single phase of Tb₃Al₅O₁₂. In this manner, it is clear that the resulting crystal is a TAG single crystal.

### Example 3

As starting materials for a raw material rod, Tb₄O₇ (purity 99.9%) and Al₂O₃ (purity 99.99%) were weighed, and a TAG polycrystal was prepared in a manner similar to that in Example 1. The density of the resulting TAG polycrystal was 80% . A crystal was prepared in a manner similar to that in Example 1, except that a Y₃Al₅O₁₂ single crystal was used as the seed crystal. With respect to the thus prepared crystal and the TAG single crystal, Laue photographs were taken in a manner similar to that in (3) of Example 1 and comparisons were performed. The reflection X-ray Laue image of the resulting crystal is in agreement with that of the TAG single crystal, and therefore, it is clear that the growing orientation can be controlled as well. The material identification of the resulting crystal was performed with an X-ray diffractometer in a manner similar to that in (4) of Example 1, and no peak other than that of the garnet phase was detected. It is clear from the above description that the resulting crystal is a TAG single crystal.

### Example 4

As starting materials for a raw material rod, Tb₄O₇ (purity 99.9%), Al₂O₃ (purity 99.99%) and Dy₂O₃ (purity 99.9%) were weighed in order to constitute DyTb₂Al₅O₁₂, and a DyTb₂Al₅O₁₂ polycrystal was prepared in a manner similar to that in Example 1. The density of the resulting DyTb₂Al₅O₁₂ polycrystal was 80%. A crystal was prepared in a manner similar to that in Example 1 except that a DyTb₂Al₅O₁₂ single crystal was used as the seed crystal. With respect to the thus prepared crystal, Laue photographs were taken in a manner similar to that in (3) of Example 1. The reflection X-ray Laue image of the DyTb₂Al₅O₁₂ single crystal used as the seed crystal is in agreement with that of the resulting crystal, and therefore, it is clear that the growing orientation can be controlled as well. The material identification of the resulting crystal was performed with an X-ray diffractometer in a manner similar to that in (4) of Example 1, and no X-ray peak value other than that of the garnet phase was detected. It is clear from the above description that the resulting crystal is a single phase of DyTb₂Al₅O₁₂ single crystal.

### Example 5

As starting materials for a raw material rod, Tb₄O₇ (purity 99.9%), Al₂O₃ (purity 99.99%) and Ho₂O₃ (purity 99.9%) were weighed in order to constitute Ho_{0.5}Tb_{2.5}Al₅O₁₂, and a Ho_{0.5}Tb_{2.5}Al₅O₁₂ polycrystal was prepared in a manner similar to that in Example 1. The density of the resulting Ho_{0.5}Tb_{2.5}Al₅O₁₂ polycrystal was 80% . A crystal was prepared in a manner similar to that in Example 1 except that a Ho_{0.5}Tb_{2.5}Al₅O₁₂ single crystal was used as the seed crystal. With respect to the thus prepared crystal, Laue photographs were taken in a manner similar to that in (3) of Example 1. The reflection X-ray Laue image of the Ho_{0.5}Tb_{2.5}Al₅O₁₂ single crystal used as the seed crystal is in agreement with that of the resulting crystal, and therefore, it is clear that the growing orientation can be controlled as well. The material identification of the resulting crystal was performed with an X-ray diffractometer in a manner similar to that in (4) of Example 1, and no X-ray peak value other than that of the garnet phase was detected. It is clear from the above description that the resulting crystal is a single phase of Ho_{0.5}Tb_{2.5}Al₅O₁₂ single crystal.

### Example 6

As starting materials for a raw material rod, Tb₄O₇ (purity 99.9%), Al₂O₃ (purity 99.99%) and Er₂O₃ (purity 99.9%) were weighed in order to constitute ErTb₂Al₅O₁₂, and an ErTb₂Al₅O₁₂ polycrystal was prepared in a manner similar to that in Example 1. The density of the resulting ErTb₂Al₅O₁₂ polycrystal was 80% . A crystal was prepared in a manner similar to that in Example 1 except that an ErTb₂Al₅O₁₂ single crystal was used as the seed crystal. With respect to the thus prepared crystal, Laue photographs were taken in a manner similar to that in (3) of Example 1. The reflection X-ray Laue image of the ErTb₂Al₅O₁₂ single crystal used as the seed crystal is in agreement with that of the resulting crystal, and therefore, it is clear that the growing orientation can be controlled as well. The material identification of the resulting crystal was performed with an X-ray diffractometer in a manner similar to that in (4) of Example 1, and no X-ray peak value other than that of the garnet phase was detected. It is clear from the above description that the resulting crystal is a single phase of ErTb₂Al₅O₁₂ single crystal.

### Example 7

As starting materials for a raw material rod, Tb₄O₇ (purity 99.9%), Al₂O₃ (purity 99.99%) and Tm₂O₃ (purity 99.9%) were weighed in order to constitute Tm_{1.2}Tb_{1.8}Al₅O₁₂, and a Tm_{1.2}Tb_{1.8}Al₅O₁₂ polycrystal was prepared in a manner similar to that in Example 1. The density of the resulting Tm_{1.2}Tb_{1.8}Al₅O₁₂ polycrystal was 80%. A crystal was prepared in a manner similar to that in Example 1 except that a Tm_{1.2}Tb_{1.8}Al₅O₁₂ single crystal was used as the seed crystal. With respect to the thus prepared crystal, Laue photographs were taken in a manner similar to that in (3) of Example 1. The reflection X-ray Laue image of the Tm_{1.2}Tb_{1.8}Al₅O₁₂ single crystal used as the seed crystal is in agreement with that of the resulting crystal, and therefore, it is clear that the growing orientation can be controlled as well. The material identification of the resulting crystal was performed with an X-ray diffractometer in a manner similar to that in (4) of Example 1, and no X-ray peak value other than that of the garnet phase was detected. It is clear from the above description that the resulting crystal is a single phase of Tm_{1.2}Tb_{1.8}Al₅O₁₂ single crystal.

### Experimental example 2

TAG single crystals were prepared as starting materials for a raw material rod and a seed crystal. In addition to this, Tb₄O₇ (purity 99.9%) and Al₂O₃ (purity 99.99%) were weighed, and TAG polycrystals having densities of 55 % to 90% , as shown in Table 1, were prepared. The method for manufacturing TAG polycrystals having the thus different densities was adjusted by setting the firing temperature at 1,400°C to 1,600°C in the first step of Example 1. The resulting TAG polycrystals were molded into the shape of a cylindrical column having a diameter of 3 mm or 1 mm. Raw material rods and seed crystals were prepared in combinations shown in Table 1, and TAG single crystals were grown in a manner similar to that in Example 1.

With respect to whether the crystal prepared as described above was a TAG single crystal, the material identification was performed with an X-ray diffractometer which measured diffraction peaks based on the irradiation of the resulting crystal with an X-ray. The case where a single phase of TAG single crystal having a diameter of 3 mm was produced was indicated by 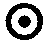 . The case where a single phase of TAG single crystal having a diameter of 3 mm was not produced, but a single phase of TAG single crystal having a diameter of 1 mm was produced was indicated by ○. The case where a TbAlO₃ phase was deposited was indicated by ^{×}. The case where no crystal was generated due to occurrence of crack or breaking of the melt zone was indicated by ^{× ×}.

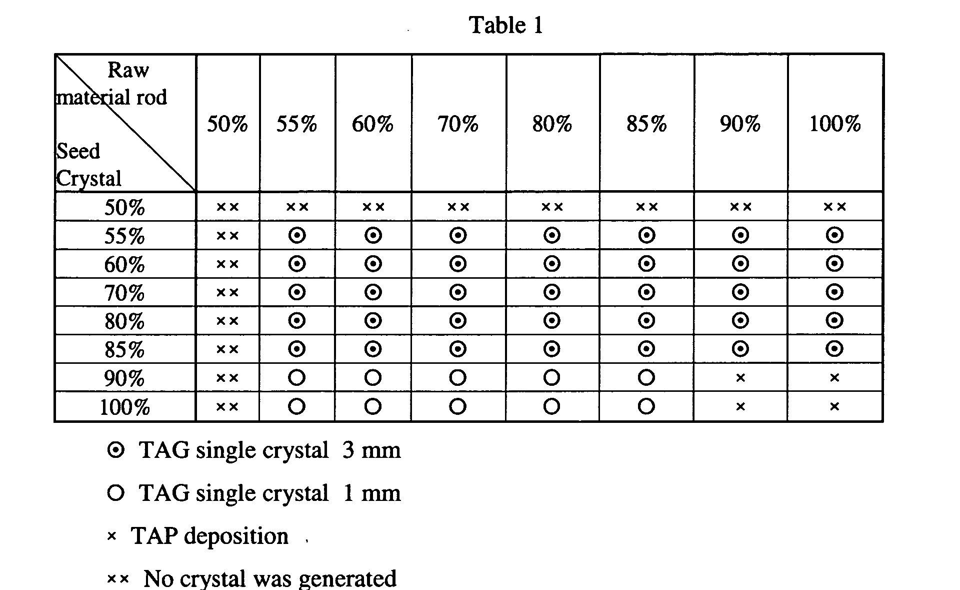

As is clear from Table 1, a single phase of TAG single crystal can be produced when at least one of the raw material rod and the seed crystal is porous, one of the raw material rod and the seed crystal has a density of about 55% or more but 100% or less, and the other has a density of about 55 % or more but about 85 % or less.

In particular, it is made clear that a single phase of TAG single crystal having a diameter of 3 mm can be produced as well with respect to the crystals produced from the seed crystal having a density within the range of about 55% or more but about 85% or less and the raw material rod having a density within the range of about 55% or more but 100% or less.

On the other hand, it is made clear that TbAlO₃ is deposited in a single crystal in the case where TAG single crystal is used for both the seed crystal and the raw material rod, and in the case where both the seed crystal and the raw material rod have densities exceeding about 85%. It is believed that this is because the raw material rod and the seed crystal are not porous, and therefore, an initial phase of TbAlO₃ is deposited in a single crystal by heat-melting.

In the case where both the seed crystal and the raw material rod have densities of less than about 55%, the molten liquid excessively penetrates into the holes, and thereby, the single crystal becomes too slender, so that the melt zone is broken or cannot be stably held.

### Comparative example 1

YIG single crystals were prepared as starting materials for a raw material rod and a seed crystal. In addition to this, Y₂O₃ (purity 99.9%) and Fe₂O₃ (purity 99.99%) were weighed, and YIG polycrystals having densities of 55 % to 90%, as shown in Table 2, were prepared. The method for manufacturing TAG polycrystals having the thus different densities was adjusted by setting the firing temperature at 1,400°C to 1,460°C in the first step of Example 1. Except above, YIG single crystals were grown in a manner similar to that in the experimental example 2. The result is shown in Table 2.

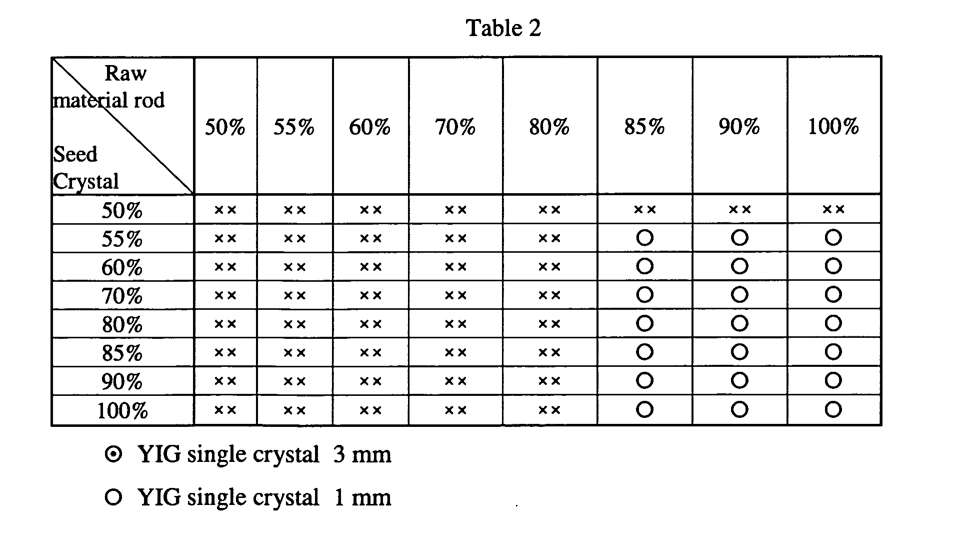

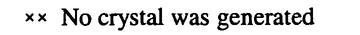

As is clear from Table 2, it is clear that YIG single crystal is not produced when a density of the raw material rod is less than 85%, a density of the seed crystal is less than 80% .

## Claims

1. A method for manufacturing a terbium aluminum-based paramagnetic garnet single crystal by a laser FZ method using a raw material rod of paramagnetic garnet containing at least Tb and Al and a seed crystal, the method comprising :
providing a melt-joined raw material rod and seed crystal, wherein at least one of the raw material rod and the seed crystal is porous;
heat-melting the joint of the seed crystal and the raw material rod by application of optical energy thereto so as to prepare a melt zone; and
cooling the resulting melt zone.

2. The method for manufacturing a terbium aluminum-based paramagnetic garnet single crystal according to Claim 1, wherein the density relative to theoretical density of the raw material rod and seed crystal are different and one of the raw material rod and the seed crystal has a relative density of about 55% to 100% , and the other has a relative density of about 55 % to 85 % .

3. The method for manufacturing a terbium aluminum-based paramagnetic garnet single crystal according to Claim 2, wherein the seed crystal has a relative density of about 55 % to 85 % or less and the raw material rod has a density of relative 55% to 100% and the seed crystal has a lower density than the raw material rod.

4. The method for manufacturing a terbium aluminum-based paramagnetic garnet single crystal according to Claim3, wherein the seed crystal is a Tb₃Al₅O₁₂ single crystal, a Tb₃Al₅O₁₂ polycrystal or Y₃Al₅O₁₂ .

5. The method for manufacturing a terbium aluminum-based paramagnetic garnet single crystal according to Claim 4, wherein the raw material rod comprises Tb₃Al₅O₁₂ or (RTb)₃Al₅O₁₂ in which R represents at least one rare-earth element.

6. The method for manufacturing a terbium aluminum-based paramagnetic garnet single crystal according to Claim 5, wherein the joint of the raw material rod and the seed crystal is heat-melted by application of CO₂ gas laser light thereto.

7. The method for manufacturing a terbium aluminum-based paramagnetic garnet single crystal according to Claim 6, wherein the laser light is condensed before the CO₂ gas laser light is applied to the joint of the raw material rod and the seed crystal.

8. The method for manufacturing a terbium aluminum-based paramagnetic garnet single crystal according to Claim 1, wherein the seed crystal is a Tb₃Al₅O₁₂ single crystal, a Tb₃Al₅O₁₂ polycrystal or Y₃Al₅O₁₂ .

9. The method for manufacturing a terbium aluminum-based paramagnetic garnet single crystal according to Claim 8, wherein the raw material rod comprises Tb₃Al₅O₁₂ or (RTb)₃Al₅O₁₂ in which R represents at least one rare-earth element) .

10. The method for manufacturing a terbium aluminum-based paramagnetic garnet single crystal according to Claim 9, wherein the joint of the raw material rod and the seed crystal is heat-melted by application of CO₂ gas laser light thereto.

11. The method for manufacturing a terbium aluminum-based paramagnetic garnet single crystal according to Claim 10, wherein the laser light is condensed before the CO₂ gas laser light is applied to the joint of the raw material rod and the seed crystal.

12. The method for manufacturing a terbium aluminum-based paramagnetic garnet single crystal according to Claim 1, wherein the raw material rod comprises Tb₃Al₅O₁₂ or (RTb)₃Al₅O₁₂ in which R represents at least one rare-earth element.

13. The method for manufacturing a terbium aluminum-based paramagnetic garnet single crystal according to Claim 12, wherein R is selected from the group consisting of Y, Dy, Ho, Er and Tm.

14. The method for manufacturing a terbium aluminum-based paramagnetic garnet single crystal according to Claim 1, wherein the joint of the raw material rod and the seed crystal is heat-melted by application of CO₂ gas laser light thereto.

15. The method for manufacturing a terbium aluminum-based paramagnetic garnet single crystal according to Claim 15, wherein the laser light is condensed before the CO₂ gas laser light is applied to the joint of the raw material rod and the seed crystal.

16. The method for manufacturing a terbium aluminum-based paramagnetic garnet single crystal according to Claim 1, further comprising melt-joining the raw material rod and seed crystal.

17. The method for manufacturing a terbium aluminum-based paramagnetic garnet single crystal according to Claim 1, further comprising preparing the raw material rod and seed crystal.

18. The method for manufacturing a terbium aluminum-based paramagnetic garnet single crystal according to Claim 17, wherein the raw material rod and seed crystal are prepared such that their densities relative to theoretical density are different and one of the raw material rod and the seed crystal has a relative density of about 55 % to 100% , and the other has a relative density of about 55 % to 85% .

19. The method for manufacturing a terbium aluminum-based paramagnetic garnet single crystal according to Claim 18, wherein the raw material rod and seed crystal are prepared such that the relative density of the seed crystal is smaller than the relative density of the raw material rod.
